# EUROPEAN PATENT APPLICATION

(11) **EP 1 312 698 A1**
(43) Date of publication of application: **21.05.2003**
(21) Application number: 02257886.8
(22) Date of filing: 14.11.2002
(51) Int. Cl.: C23C 16/46, H01L 21/00

(54) **Heating element CVD System and heating element CVD method using the same**

(30) Priority: 14.11.2001 JP 2001349075
(71) Applicant: ANELVA CORPORATION, Fuchu-shi, Tokyo 183-8508 (JP)
(72) Inventor: Karasawa, Minoru, Anelva Corporation, Fuchu-shi, Tokyo 183-8508 (JP); Ishibashi, Keiji, Anelva Corporation, Fuchu-shi, Tokyo 183-8508 (JP); Tanaka, Masahiko, Anelva Corporation, Fuchu-shi, Tokyo 183-8508 (JP)
(74) Representative: Lyndon-Stanford, Edward Willoughby Brooke

(57) **Abstract**

A heating element CVD system and method for forming a high quality polycrystalline silicon film (a polysilicon film). The system has a processing chamber (1) for processing a substrate (9) held by a substrate holder (5) in the chamber (1), with an evacuating system (2) for providing a vacuum in the chamber (1), a gas supply system (3) for supplying a specific gas to the chamber (1) and a heating element (4) with an electric power supply system (6) to maintain the heating element (4) at a high temperature. A structure (8) surrounds the space between the holder (5) and the heating element (4), and the inner surface of the structure (8) is heated to at least 200°C, preferably at least 350°C, while a silicon film is formed on the substrate (9) by decomposition and/or activation of the gas.

## Description

### BACKGROUND OF THE INVENTION

### Field of the Invention

The present invention relates to a heating element CVD system and a heating element CVD method for depositing a thin film on a substrate disposed in the vacuum chamber (processing chamber) by providing a heating element maintained at a predetermined temperature in a vacuum chamber (processing chamber), and decomposing and/or activating a material gas by the said heating element.

### Description of the Related Art

In production of various kinds of semiconductor devices such as an LSI (large scale integrated circuit), LCDs (liquid crystal displays), solar cells, or the like, the chemical vapor deposition (CVD) method is used widely as a process for forming a predetermined thin film on a substrate.

As the CVD method in addition to a plasma CVD method for forming a film by decomposing and/or activating a material gas in a discharge plasma, a thermal CVD method for forming a film by heating a substrate for generating the chemical reaction by the heat, or the like, a CVD method for forming a film by decomposing and/or activating a material gas by a heating element maintained at a predetermined high temperature (hereinafter referred to as the "heating element CVD method) can be presented. A film formation processing system for executing the heating element CVD method (heating element CVD system) is provided in a configuration of introducing a material gas while maintaining a heating element made of a high melting point metal such as a tungsten at a high temperature of about 1,000 to 2,000°C in a processing chamber capable of evacuating to the vacuum. The introduced material gas is decomposed or activated at the time of passing by the surface of the heating element. By having the same reaching at a substrate, a thin film of a finally targeted substance (such as a silicon film) is deposited on the substrate surface.

Among the heating element CVD methods, those using a wire-like heating element are referred to as a hot wire CVD method. Moreover, those utilizing the catalytic-CVD reaction of a heating element in the decomposition or activation of the material gas by the heating element are referred to as a catalytic-CVD (Cat-CVD) method.

According to the heating element CVD method, since the decomposition or activation of the material gas is generated at the time of passing by the heating element, compared with the thermal CVD method of generating reaction only by the heat of the substrate, it is advantageous in that the substrate temperature can be made lower. Moreover, unlike the plasma CVD method, since the plasma is not formed, a problem of the damage on the substrate by the plasma can be eliminated. From these viewpoints, the heating element CVD method is regarded as a promising film forming method for the next generation devices or the like with the larger scale integration and higher function.

However, although the heating element CVD method is highly useful, it has not achieved stable formation of a high quality polycrystalline silicon film with a good reproductivity. Here, the high quality polycrystalline silicon film refers to those having for example, the electron mobility improved to 20 cm²/Vs as the electronic devices. In general, in the case a silicon film is formed using a conventional heating element CVD system, although a polycrystalline state can be realized, the degree of crystallization in the stage after the film formation is not good, and a film quality close to the amorphous state is provided. That is, the as-deposited polycrystalline silicon film formed by a conventional heating element CVD method has not attained the quality required for the electronic devices in the industry.

Therefore, the present inventors have studied elaborately, paying attention to the importance of the film formation environment at the time of the silicon film formation in the processing chamber, in particular, the importance of maintenance and stabilization of the atomic hydrogen for establishment of the apparatus configuration and the film forming method capable of maintaining the film forming environment which are not present in prior art.

That is, the present inventors concluded that, in a silicon film formation, it is indispensable for the high quality polycrystalline silicon film formation to create the environment where the deactivation of an atomic hydrogen produced in decomposition process and/or activation process of silane (SiH₄) or hydrogen (H₂) can be restrained, thereby the atomic hydrogen can exist stably in the processing chamber. And the present inventors aimed at putting into practice as the heating element CVD system and the heating element CVD method of the present invention.

A silicon film is formed on a substrate by decomposing and/or activating a silane (SiH₄) or a hydrogen (H₂) as the material gas by a heating element. At the same time, a silicon film is formed on the inner wall of processing chamber. And the atomic hydrogen produced in the decomposition process and/or activation process of silane (SiH₄) or hydrogen (H₂) produces a secondary product by the reaction with the adhered film deposited on the inner wall of processing chamber, this influences the quality of the silicon film in the formation process on the substrate so as to disturb production of a high quality silicon film. This phenomenon is also learned.

This phenomenon is reported by Atsushi Masuda, et al. in the preliminary reports for the lectures for the 48^{th} applied physics related association assembly 2001 29a-ZQ-3, p. 949.

### SUMMARY OF THE INVENTION

In view of the above-mentioned conventional heating element CVD system and heating element CVD method, an object of the present invention is to provide a heating element CVD system and a heating element CVD method capable of forming a high quality polycrystalline silicon film (polysilicon film) as a device, in the case of producing a silicon film using a heating element CVD system.

Like the conventionally known heating element CVD system, a heating element CVD system proposed by the present invention comprises a processing chamber(vacuum chamber) for applying a predetermined process to a substrate held by a substrate holder provided inside the said processing chamber, an evacuating system connected with the processing chamber for evacuating the inside of the processing chamber to the vacuum, a material gas supplying system for supplying a predetermined material gas into the processing chamber, and a heating element disposed in the processing chamber for receiving the electric power supply from an electric power supplying mechanism so as to be at a high temperature. Then, a thin film is formed on the substrate held by the substrate holder by the decomposition and/or the activation of the material gas introduced from the material gas supplying system into the processing chamber by the heating element maintained at a high temperature.

According to the heating element CVD system of the above-mentioned configuration, in the heating element CVD system proposed by the present invention, the inner surface of a structure surrounding the space between the substrate holder and the heating element is heated during the film formation of the thin film on the substrate.

According to the heating element CVD system of the present invention, since the inner surface of the structure surrounding the space between the substrate holder and the heating element is heated during the film formation of the thin film, such as a silicon film, on the substrate, the atomic hydrogen can exist stably in the space between the substrate holder and the heating element, and the specific environment can be obtained under which the secondary product, generated at the same time when the silicon film is formed, can be reduced. Thereby, a high quality polycrystalline silicon film can be formed.

In the above-mentioned heating element CVD system of the present invention, the before described predetermined process denotes, for example, the thin film formation on the substrate disposed in the processing chamber, cleaning for eliminating the adhered substance on the processing chamber inside, or the like. Moreover, the predetermined material gas can be determined variously depending on the thin film to be formed. For example, in the case of forming a silicon film, a gas mixture of a silane (SiH₄) and a hydrogen (H₂) is used as the predetermined material gas. And, in the case of forming a silicon carbide film, a gas mixture of silane(SiH₄), hydrogen(H₂) and at least one selected from the group consisting of a methane(CH₄), and acetylene(C₂H₂) and an ethane (C₂H₆) is used as the predetermined gas. Also, in the case of forming a silicon germanium film, a gas mixture of silane(SiH₄), germane(GeH₄) and hydrogen(H₂) is used as the predetermined gas. Furthermore, the high temperature at which the heated heating element maintains is about 1,600 to 2,000°C at the time of the film formation, and about 2,000 to 2,500°C at the time of cleaning (at the time of eliminating the adhered substance on the processing chamber inside).

In the before described heating element CVD system of the present invention, as the structure surrounding the space between the substrate holder and the heating element, any one may be adopted as long as it is a structure provided with a heating mechanism in itself, such as a jig provided with a heating mechanism in itself and surrounding the space between the substrate holder and the heating element in consideration of the efficiency in terms of the electric power.

Therefore, a heating jig disposed so as to surround the space between the substrate holder and the heating element inside of the inner wall of the processing chamber and a heating of the inner surface of the said heating jig is carried out by a heating mechanism stored therein can be adopted as the structure surrounding the space between the substrate holder and the heating element.

Moreover, it is also possible to use the inner wall of the processing chamber as the structure surrounding the space between the substrate holder and the heating element. In this case, the heating of the inner surface of the structure(inner wall of the processing chamber) is carried out by a heating mechanism stored in the inner wall of the processing chamber.

The heating mechanism may be composed of for example, a heater, a temperature detection sensor, a heating temperature adjusting device for adjusting the input electric power to the heater based on a signal from the temperature detection sensor, or the like.

Furthermore, in the above-mentioned heating element CVD system of the present invention, the heating is carried out so as to have the inner surface of the structure heated and maintained at least 200°C or higher, preferably 350°C or higher.

It is preferable to maintain the temperature of the inner surface of the structure at least 350°C or higher in a pressure range in which the heating element CVD system is used ordinarily, such as a several tens Pa area. In the several tens Pa pressure area, by surrounding the space between the substrate holder and the heating element by the inner surface of the structure maintained at least 350°C or higher, during the film formation of the silicon film on the substrate, the atomic hydrogen can exist stably in the said space, and the specific environment can be obtained under which the secondary product, generated at the same time during the film formation of the silicon film, can be reduced.

In the case the heating element CVD system is used in a slightly low pressure range, such as a several Pa area, by maintaining the temperature of the inner surface of the structure at least 200°C or higher, during the film formation of the silicon film on the substrate, the atomic hydrogen can exist stably in the said space between the substrate holder and the heating element, and the specific environment can be obtained under which the secondary product, generated at the same time during the film formation of the silicon film, can be reduced. Therefore, in the case the heating element CVD system is used in a slightly low pressure range, such as several Pa, it is sufficient to maintain the temperature of the inner surface of the structure at least 200°C or higher.

The upper limit of the temperature of the inner surface of the structure surrounding the space between the substrate holder and the heating element is not particularly limited as long as it is in a temperature range not to give the thermal damage on the substrate with the thin film formed.

Next, in order to achieve the above-mentioned object, a heating element CVD method proposed by the present invention is carried out using the above-mentioned heating element CVD system of the present invention, wherein the thin film formed on the substrate is anyone of silicon film, silicon carbide film, or silicon germanium film, etc., and the inner surface of the structure surrounding the space between the substrate holder and the heating element is heated and maintained at least 200°C or higher, preferably 350°C or higher during the film formation of the before described silicon films for the above-mentioned reason.

According to the heating element CVD system and the heating element CVD method of the present invention, by forming a silicon film, silicon carbide film,or silicon germanium film, etc., with heating the inner surface of the structure surrounding the space between the substrate holder and the heating element and maintaining the temperature of the said inner surface at least 200°C or higher, preferably at least 350°C or higher, a high quality polycrystalline silicon film having a good device characteristic can be formed.

### BRIEF DESCRIPTION OF THE DRAWINGS

Fig. 1 is a front cross-sectional schematic view for explaining the configuration of a heating element CVD system of the present invention.

Fig. 2 is a cross-sectional schematic view of a material gas supplying device used for the heating element CVD system of Fig.1.

Fig. 3(a) is a partially omitted view of the inside of a processing chamber in a heating element CVD system of the present invention viewed from above, and Fig. 3(b) is a perspective view of the side surface of a heating jig.

### DETAILED DESCRIPTION OF THE INVENTION

Hereinafter, with reference to the accompanied drawings, preferable embodiments of the present invention will be explained. However, the configuration, the shaped and the arrangement relationships are shown schematically to the degree that the present invention can be understood, and furthermore, the numerical values and the compositions (materials) of the configurations are merely examples. Therefore, the present invention is not limited to the embodiments explained below, and it can be modified in various forms within the technological scope grasped from the claims.

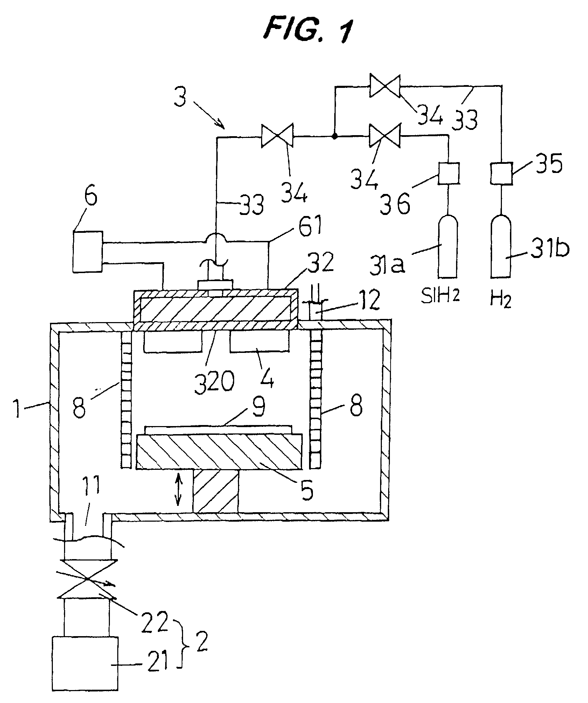

Fig. 1 is a front cross-sectional schematic view for explaining the configuration of a heating element CVD system of the present invention.

The heating element CVD system shown in Fig. 1 provides a processing chamber 1. A predetermined process, such as the thin film formation on a substrate 9, and cleaning, is carried out inside the processing chamber 1. The processing chamber 1 provides an evacuating system 2 for evacuating the inside of the processing chamber 1 to a predetermined pressure. Moreover, the processing chamber 1 is connected with a gas supplying system 3 for supplying a predetermined material gas (such as a silane (SiH₄) gas and a hydrogen (H₂) gas in the case of producing a silicon film) into the processing chamber 1. A heating element 4 is provided in the processing chamber 1 such that the supplied material gas passes by the surface. The heating element 4 is connected with an electric power supplying mechanism 6 for giving an energy for maintaining the heating element 4 at a predetermined high temperature (such as 1,600°C to 2,500°C). The substrate 9 is held by a substrate holder 5 at a predetermined position in the processing chamber 1. The material gas supplied into the processing chamber 1 as the before described is decomposed and/or activated by the heating element 4 maintained at the predetermined high temperature so that a predetermined thin film is produced on the substrate 9. The substrate holder 5 can be moved in the vertical direction by an unshown driving system.

Moreover, the substrate 9 and the substrate holder 5 are contacted closely by an unshown electrostatic chucking mechanism. At the time of forming a silicon film, the substrate 9 is heated at 300 to 350°C.

As shown in Fig. 1, the heating element 4 is held by a material gas supplying device 32. The material gas supplying device 32 is connected with the gas supplying system 3 such that a material gas is introduced into the processing chamber 1 via the material gas supplying device 32 so as to pass by the heating element 4 maintained at a predetermined high temperature.

The processing chamber 1 is an airtight vacuum chamber, providing an unshown gate valve for placing or removing the substrate 9.

The processing chamber 1 provides an evacuating opening 11 such that the inside of the processing chamber 1 can be evacuated through the evacuating opening 11.

The evacuating system 2 provides a vacuum pump 21 such as a turbo molecular pump. The evacuating system 2 connected with the evacuating opening 11 of the processing chamber 1 is provided so as to evacuate the inside of the processing chamber 1 to about 10⁻⁵ to 10⁻⁷ Pa. The evacuating system 2 provides an evacuation speed adjusting device 22 such as a variable orifice.

The gas supplying system 3 is composed of a gas bomb 31a storing a silane (SiH₄) as the material gas, a gas bomb 31b storing a hydrogen (H₂) to be mixed with the silane (SiH₄), a pipe 33 connecting the gas bombs 31a, 31b and the material gas supplying device 32, a valve 34 and a flow rate adjusting device 35 provided on the pipe 33.

That is, the silane (SiH₄) and the hydrogen (H₂) from the gas bombs 31a, 31b are mixed halfway in the pipe 33 become the material gas so as to be introduced into the material gas supplying device 32. The material gas is blown from a gas blowing hole 320 of the material gas supplying device 32 toward the heating element 4 so as to be supplied into the processing chamber 1.

The heating element 4 is made of a high melting point metal, such as a tungsten, a molybdenum, and a tantalum. Moreover, the electric power supplying system 6 is composed so as to energize the heating element 4 for generate the Joule's heat in the heating element 4. That is, the electric power supplying mechanism 6 is composed so as to maintain the heating element 4 at a predetermined high temperature, for example about 1,600°C to 2,500°C by supplying the electric power.

In Fig. 1, the member shown by the numeral 8 is a structure (heating jig) providing a heating mechanism in itself, for surrounding the space between the substrate holder 5 and the heating element 4, which is characteristic of the heating element CVD system of the embodiment of the present invention.

As shown in Fig. 1, the heating jig 8 is disposed so as to surround the space between the substrate holder 5 and the heating element 4 on the inner side of the inner wall of the processing chamber 1. The inner wall of the heating jig 8 is heated and maintained at least 200°C or higher, preferably at least 350°C or higher by the heating mechanism stored in the heating jig 8.

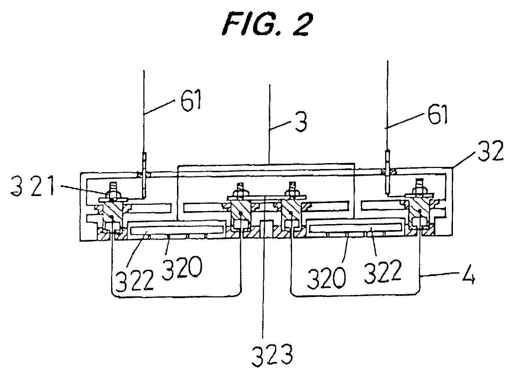

Fig. 2 is a cross-sectional schematic view of the material gas supplying device 32 with the heating element 4 held. The material gas supplying device 32 is composed of connecting terminals 321 connected with a wiring 61 for holding the heating element 4, interlocked with the electric power supplying mechanism 6 for supplying the electric power to the heating element 4, an interlocking plate 323 for connecting the connecting terminals 321, and material gas supplying chambers 322 connected with the material gas supplying system 3 for supplying the supplied material gas from the gas blowing hole 320 into the processing chamber 1 passing through the heating element 4.

Since the construction in which the connecting terminals 321 and the interlocking plate 323 are not contacted with the material gas is adopted, there is no risk of corrosion, deterioration, or the like.

Since the heating element 4 is fixed on the connecting terminals 321 fixed on the inside of the material gas supplying device 32 by a pressuring spring (not shown) or the like, it can be detached easily. Moreover, the distance between the substrate 9 and the heating element 4 can be adjusted and/or the distance between the heating elements 4 mounted on the material gas supplying device 32 can be adjusted according to the size of the substrate 9 held by the substrate holder 5, the process condition, or the like.

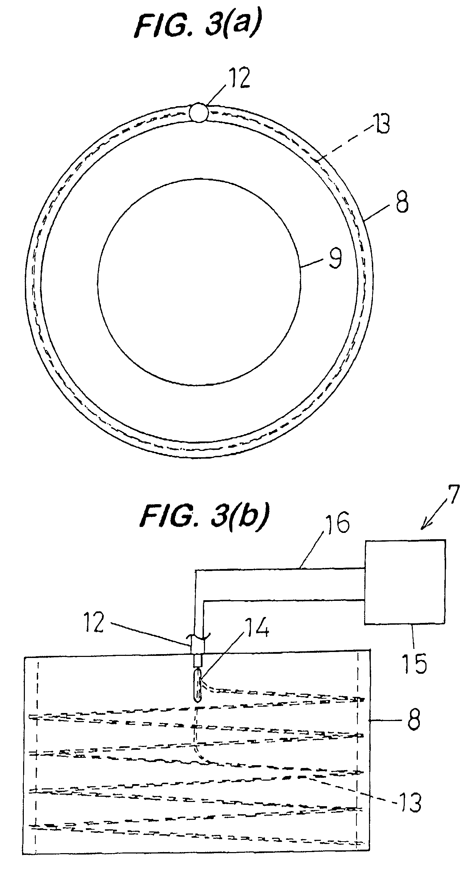

Fig. 3(a) is a partially omitted view of the inside of the processing chamber 1 of an embodiment of a heating element CVD system characteristic of the present invention, viewed from above (from the material gas supplying device 32 side) to the substrate holder 5 side. In order to explain the installation position of the heating jig 8 for surrounding the space between the substrate holder 5 and the heating element 4, the positional relationship of the heating jig 8 is shown with respect to the substrate 9 held by the substrate holder 5. Fig. 3(b) is a perspective view of the side surface of a heating jig 8.

In Fig. 3(a), the substrate 9 held on the substrate holder (not shown) is disposed on the center of the processing chamber 1, with the outer circumference thereof surrounded by the heating jig 8 storing the heater 13.

The embodiment is advantageous for effectively heating the space between the substrate holder 5 and the heating element 4.

The method for fixing the processing chamber 1 and the heating jig 8 is not limited to the embodiment of being fixed on the upper surface of the processing chamber 1 (shown in Fig. 1), and a structure without hindering the conveyance of the substrate 9 to the substrate holder 5, such as an embodiment of being supported on the lower surface of the processing chamber 1 (connecting surface of the evacuating opening 11) by a fixing bracket can be adopted as well.

In Fig. 3(b), the numeral 7 denotes a heating mechanism 7 for heating and maintaining the inner wall of heating jig 8 at a predetermined temperature. The heating mechanism 7 is composed of a heater 13 stored in the heating jig 8, a sensor 14 for detecting the temperature of the heating jig 8, a heating temperature adjusting device 15 for adjusting the input electric power to the heater 13 based on a signal from the sensor 14, a wiring 16 for connecting the heater 13, the sensor 14 and the heating temperature adjusting device 15, and a connecting part 12 provided on the heating jig 8 for the wiring 16.

Moreover, in Fig.3(b), although the heater 13 is wound spirally for even heating and temperature adjustment, the arrangement of the heater 13 in the heating jig 8 is not limited thereto. Furthermore, in Fig.3(b), although the heater 13 is stored in the heating jig 8 for preventing corrosion or deterioration by the contact with the material gas (silane, hydrogen), the heater 13 can be arranged optionally as long as the heating and temperature adjustment can be carried out so as to maintain the inner wall of the heating jig 8 at least 200°C or higher, or at least 350°C or higher and corrosion and deterioration of the heater 13 is prevented.

The embodiment of the heating element CVD system of the present invention is not limited as the before described.

For example, although it is not shown, an embodiment having the structure surrounding the space between the substrate holder 5 and the heating element 4 is the inner wall of the processing chamber 1 such that a heating of the inner surface of the structure is carried out by a heating mechanism stored in the inner wall of the processing chamber 1 thereby the inner wall of the processing chamber 1 can be heated and maintained at least 200°C or higher, preferably at least 350°C or higher can be adopted as well.

Next, the operation of the system of an embodiment shown in Figs. 1 to 3(b) will be explained together with the explanation for the CVD method of the present invention.

The inside of the preliminary vacuum chamber(not shown) and the processing chamber 1 is evacuated to a predetermined pressure with the substrate 9 disposed in a preliminary vacuum chamber. With a gate valve (not shown) opened, the substrate 9 is conveyed into the processing chamber 1 by an unshown conveying mechanism. According to an unshown driving system, the substrate holder 5 is moved vertically so that the substrate 9 is placed and held on the substrate holder 5.

At the time, the substrate holder 5 is maintained at a predetermined temperature (for example, 300 to 350°C), and the substrate 9 and the substrate holder 5 are contacted closely by the electrostatic chuck (not shown).

Next, the electric power supplying mechanism 6 starts to energize the heating element 4 so as to maintain the heating element 4 at a predetermined high temperature. Moreover, the heater 13 stored in the heating jig 8 is energized so as to operate the heating temperature adjusting device 15 for heating the heater13 to a predetermined temperature, for example 350°C. In the case the heating element 4 is maintained at a predetermined temperature, and the inner surface temperature of the heating jig 8 is confirmed to have reached at 350°C by the sensor 14, the gas supplying system 3 is operated so that the material gas, that is, a silane gas mixed with a hydrogen gas is introduced into the processing chamber 1 while adjusting the flow rate by the flow rate adjusting device 35. Thereafter, the inside of the processing chamber 1 is maintained at a predetermined pressure by the evacuating system 2.

The electric power supply amount of the heater 13 is adjusted such that the inner surface of the heating jig 8 is maintained at least 350°C or higher in the case the heating element CVD system of the present invention is used in a several tens Pa pressure area, and the inner surface of the heating jig 8 is heated and maintained at least 200°C or higher in the case the heating element CVD system of the present invention is used in a relatively low pressure range, for example, of a several Pa pressure area.

Since it takes a long time for heating to 350°C or higher, the production efficiency can be improved by adjusting the temperature to 200°C or higher even in the case the film forming is not executed for shortening the heating time to 350°C or higher.

As a result, the material gas decomposed and/or activated on the surface of the heating element 4 can efficiently reach the surface of the substrate 9 so that a polycrystalline silicon film can be deposited on the surface of the substrate 9.

After passage of a time needed for having the thin film thickness reaching at a predetermined thickness, the valve 34 of the gas supplying system 3 is closed as well as the operation of the electric power supplying mechanism 6 is stopped. As needed, the electric power supply to the heating element 4 and the heater 13 may be blocked.

After operating the evacuating system 2 so as to evacuate the inside of the processing chamber 1 again to the predetermined pressure, the unshown gate valve is opened for taking out the substrate 9 from the processing chamber 1 by the unshown conveying mechanism. Thereby, a series of the film forming process can be finished.

An example of the film forming condition for forming a silicon film (film thickness: 1,000 nm) by a CVD method of the present invention using a heating element CVD system of the present invention will be shown below. In this example, a heating jig 8 surrounding the space between the substrate holder 5 and the heating element 4 on the inner side of the processing chamber 1 as in the embodiment shown in Fig. 1 is used as the structure surrounding the space between the substrate holder 5 and the heating element 4.

| | |
|---|---|
| Substrate | φ8 Si substrate |
| Pressure in the processing chamber 1 | 2 Pa |
| SiH₄ flow rate | 3 ml/min |
| H₂ flow rate | 100 ml/min |
| Temperature of the heating element 4 | 1,800°C |
| Temperature of the inner surface of the heating jig 8 | 350°C |
| Distance between the heating element 4 and the substrate 9 | 45 mm |

In contrast, a silicon film (film thickness: 1,000 nm) was formed in the same condition except that the heating operation by the heating jig 8 was not carried out, using the same heating element CVD system, and it was provided as a comparative example.

The electron mobility was measured for the both silicon films (film thickness: 1,000 nm).

As a result, it was confirmed that the electron mobility of the silicon film of the comparative example was at most 1 cm²/Vs, which is substantially same as an amorphous film, but the electron mobility was improved according to the silicon film formed with the inner surface of the heating jig 8 maintained at 350°C using the system and the method of the present invention.

The other heating element CVD system of the present invention is used, in which the inner wall of the processing chamber 1 is used as the structure surrounding the space between the substrate holder 5 and the heating element 4. A silicon film (film thickness:1,000nm) was formed in the same condition as the before described using this heating element CVD system with the inner surface of the wall of processing chamber 1 maintained at 350°C. The electron mobility was measured for this silicon film. And, it was also confirmed that the electron mobility of this silicon film was improved.

Although preferable embodiments in the polycrystalline silicon film formation have been described in the above-mentioned examples, the configuration of the heating element CVD system and the heating element CVD method disclosed in the present invention are essential in stably forming of high quality thin film. Therefore, the heating element CVD system and the heating element CVD method using the same of the present invention can be adopted for formation of the kinds of films with the atomic hydrogen produced during the film formation, such as a silicon carbide film obtained using the material gas comprising at least one selected from the group consisting of a methane (CH₄), an acetylene (C₂H₂) and an ethane (C₂H₆), and a silane (SiH₄) and a hydrogen (H₂), a silicon germanium film obtained using the material gas comprising a silane (SiH₄), a germane (GeH₄) and a hydrogen (H₂), or the like.

## Claims

1. A heating element CVD system comprising a processing chamber for applying a predetermined process to a substrate held by a substrate holder provided inside the said processing chamber, an evacuating system connected with the processing chamber for evacuating the inside of the processing chamber to vacuum, a material gas supplying system for supplying a predetermined material gas into the processing chamber, and a heating element disposed in the processing chamber for receiving the electric power supply from an electric power supplying mechanism so as to be at a high temperature, for forming a thin film on the substrate held by the substrate holder by the decomposition and/or the activation of the material gas introduced from the material gas supplying system into the processing chamber by the heating element maintained at a high temperature,
wherein the inner surface of a structure surrounding the space between the substrate holder and the heating element is heated during the film formation of the thin film on the substrate.

2. A heating element CVD system according to claim 1, wherein the structure surrounding the space between the substrate holder and the heating element is a heating jig surrounding the space between the substrate holder and the heating element and disposed inside of the inner wall of the processing chamber, and heating of the inner surface of the structure is carried out by a heating mechanism stored in the said heating jig.

3. A heating element CVD system according to claim 1, wherein the structure surrounding the space between the substrate holder and the heating element is the inner wall of the processing chamber, and heating of the inner surface of the structure is carried out by a heating mechanism stored in the said inner wall.

4. A heating element CVD system according to claim 1, wherein a heating is carried out so as to heat and maintain the inner surface of the structure at least 200°C or higher.

5. A heating element CVD system according to claim 1, wherein a heating is carried out so as to heat and maintain the inner surface of the structure at least 350°C or higher.

6. A heating element CVD system according to claim 1, wherein the thin film formed on the substrate is a silicon film.

7. A heating element CVD system according to claim 1, wherein the thin film on the substrate is a silicon carbide film.

8. A heating element CVD system according to claim 1, wherein the thin film formed on the substrate is a silicon germanium film.

9. A heating element CVD method using a heating element CVD system comprising a processing chamber for applying a predetermined process to a substrate held by a substrate holder provided inside the said processing chamber, an evacuating system connected with the processing chamber for evacuating the inside of the processing chamber to vacuum, a material gas supplying system for supplying a predetermined material gas into the processing chamber, and a heating element disposed in the processing chamber for receiving the electric power supply from an electric power supplying mechanism so as to be at a high temperature, for forming a thin film on the substrate held by the substrate holder by the decomposition and/or the activation of the material gas introduced from the material gas supplying system into the processing chamber by the heating element maintained at a high temperature,
wherein the thin film formed on the substrate is a silicon film, and the inner surface of the structure surrounding the space between the substrate holder and the heating element is heated and maintained at least 200°C or higher during the film formation of the silicon film.

10. A heating element CVD method according to claim 9, wherein the inner surface of the structure surrounding the space between the substrate holder and the heating element is maintained at least 350°C or higher during the film formation of the silicon film.

11. A heating element CVD method according to claim 9, wherein the thin film formed on the substrate is a silicon carbide film.

12. A heating element CVD method according to claim 9, wherein the thin film formed on the substrate is a silicon germanium fim.
